# FASCICULE DE BREVET EUROPEEN

(11) **EP 3 142 151 B1**
(45) Date de publication et mention de la délivrance du brevet: **07.03.2018**
(21) Numéro de dépôt: 16188199.0
(22) Date de dépôt: 09.09.2016
(51) Int. Cl.: H01L 29/66, H01L 29/78, H01L 21/02, H01L 21/223, H01L 21/265, H01L 21/762, H01L 21/84, H01L 29/08, H01L 21/266, H01L 21/8238

(54) **PROCEDE DE REALISATION D'UNE STRUCTURE DE CANAL DE TRANSISTOR EN CONTRAINTE UNI-AXIALE**
HERSTELLUNGSVERFAHREN EINER EINACHSIG VERSPANNTEN TRANSISTORKANALSTRUKTUR
METHOD FOR PRODUCING AN UNIAXIALLY STRESSED TRANSISTOR CHANNEL STRUCTURE

(30) Priorité: 11.09.2015 FR 1558477
(43) Date de publication de la demande: 15.03.2017
(73) Titulaire: Commissariat à l'énergie atomique et aux énergies alternatives, 75015 Paris (FR)
(72) Inventeur: REBOH, Shay, 38054 Grenoble (FR); GRENOUILLET, Laurent, 38640 Claix (FR); MILESI, Frédéric, 38360 Sassenage (FR); MORAND, Yves, 38000 Grenoble (FR); RIEUTORD, François, 38120 Saint Egreve (FR)
(74) Mandataire: Brevalex

(56) Documents cités:
- US-A1- 2007 262 385
- US-A1- 2008 171 426
- US-A1- 2011 101 456
- US-A1- 2013 337 637
- US-A1- 2015 097 241

## Description

### DOMAINE TECHNIQUE ET ART ANTÉRIEUR

La présente description concerne le domaine des structures de transistors, et plus particulièrement celles dotées d'une zone de canal subissant une déformation ou contrainte mécanique.

Par déformation mécanique on entend un matériau qui a son ou ses paramètre(s) de maille cristalline allongé(s) ou écourté(s).

Dans le cas où le paramètre de maille déformé est plus important que le paramètre dit « naturel » d'un matériau cristallin, celui-ci est dit en déformation en tension. Lorsque le paramètre de maille déformé est plus petit que le paramètre de maille naturel, le matériau est dit en déformation compressive ou en compression.

A ces états de déformation mécanique, on associe des états de contraintes mécaniques. Pour autant, il est également commun de se référer à ces états de déformation comme des états de contraintes mécaniques. Dans la suite de la présente demande, cette notion de déformation (« strain » selon la terminologie anglo-saxonne) sera désignée de façon générique par le terme « contrainte ».

Une contrainte appliquée à un matériau semi-conducteur induit une modification de la maille cristalline et donc de sa structure de bande, dont va découler une modification de la mobilité des porteurs dans ce matériau.

La mobilité des électrons est augmentée (respectivement diminuée) par une contrainte en tension (respectivement en compression) du matériau semi-conducteur dans lequel ils transitent alors que la mobilité des trous sera augmentée (respectivement diminuée) lorsque le semi-conducteur est en compression (respectivement en tension).

On sait réaliser des transistors sur une couche superficielle semi-conductrice contrainte d'un substrat de type semi-conducteur isolant. La contrainte dans cette couche superficielle est généralement une contrainte bi-axiale.

Pour améliorer les performances d'un transistor à canal contraint, on peut vouloir relaxer la contrainte dans une direction orthogonale à celle dans laquelle le canal s'étend, autrement dit dans une direction orthogonale à la direction dans laquelle le courant du transistor est destiné à circuler.

Une telle relaxation peut être réalisée par gravure des bords latéraux d'une structure canal en matériau semi-conducteur contraint.

Le document US2007/0262385-A1 présente un procédé dans lequel on modifie une contrainte mécanique dans une région de canal en format des zones isolantes.

Le document US2013/00337637-A1 prévoit une implantation ionique amorphisante.

Il se pose le problème de trouver un nouveau procédé de réalisation d'un dispositif à structure semi-conductrice contrainte.

### EXPOSÉ DE L'INVENTION

Un mode de réalisation de la présente invention prévoit un procédé de fabrication de transistor(s) à structure de canal contraint comprenant des étapes de :
- formation d'un masquage sur une couche superficielle d'un substrat de type semi-conducteur sur isolant comprenant une couche de support, une couche isolante séparant la couche de support de la couche superficielle, la couche superficielle étant à base d'un matériau semi-conducteur contraint selon une contrainte bi-axiale, le masquage comprenant au moins un bloc de forme allongée disposé sur une première zone de la couche superficielle, cette première zone ayant une longueur L₁ mesurée parallèlement à une première direction et une largeur W₁ mesurée parallèlement à une deuxième direction, la première zone étant apte à former une structure de canal du transistor dans laquelle un courant est destiné à circuler dans la première direction, le masquage étant configuré de sorte qu'une ou plusieurs ouvertures de forme allongée et qui s'étendent parallèlement à la première direction sont disposées de part et d'autre du bloc de masquage et dévoilent respectivement des deuxièmes zones de la couche superficielle disposées de part et d'autre de la première zone,
- réalisation d'au moins une implantation ionique de la couche superficielle à travers les ouvertures du masquage, de sorte à rendre amorphe les deuxièmes zones et à induire une relaxation de la première zone dans la deuxième direction.

Avec, un tel procédé on peut obtenir une structure de canal à base d'un matériau contraint dans une première direction parallèle à celle dans laquelle le courant de canal est destiné à circuler et relaxé dans une deuxième direction orthogonal à la première direction, et ce sans nécessairement créer de topographie ou de relief dans la couche superficielle du substrat.

Le masquage peut être formé de plusieurs blocs de masquage parallèles distincts et séparés deux à deux par une ouverture.

On peut ainsi relaxer plusieurs premières zones semi-conductrices dans une direction parallèle à celle dans laquelle la largeur de ces zones est mesurée.

Le procédé peut comprendre en outre une étape consistant à transformer les deuxièmes zones de la couche superficielle dévoilées par les ouvertures du masquage en zones isolantes.

La transformation des deuxièmes zones, rendues amorphes, en zones isolantes, permet à la fois d'obtenir une contrainte uni-axiale dans une première zone semi-conductrice tout en mettant en oeuvre une isolation latérale de cette première zone semi-conductrice.

Selon une possibilité de mise en oeuvre, cette transformation des deuxièmes zones en zones isolantes peut être réalisée à l'aide d'au moins une étape d'implantation.

Avantageusement, l'amorphisation des deuxièmes zones et la transformation des deuxièmes zones en zones isolantes peuvent être réalisées simultanément par implantation.

Selon une possibilité de mise en oeuvre, la transformation des deuxièmes zones en zones isolantes comprend au moins une étape d'oxydation thermique.

Selon une possibilité de mise en oeuvre, une ou plusieurs des zones isolantes formées par transformation des deuxièmes zones amorphes est prévue de sorte à réaliser une séparation avec un ou plusieurs autres transistors.

Afin d'augmenter l'effet de relaxation des premières zones et après transformation des deuxièmes zones en zones isolantes, on peut retirer une épaisseur de ces zones isolantes.

Selon une possibilité de mise en oeuvre, après amorphisation des deuxièmes zones de la couche superficielle, le procédé peut comprendre des étapes de :
- retrait du masquage, puis
- formation d'au moins une grille de transistor sur la première zone semi-conductrice, puis
- croissance sur le matériau semi-conducteur de la couche superficielle de blocs de source et de drain de part et d'autre de la grille.

Selon une autre possibilité de mise en oeuvre dans laquelle le masquage est un premier masquage, le procédé peut comprendre en outre,
après formation du premier masquage et préalablement à l'amorphisation des deuxièmes zones, une étape de :
- formation d'un deuxième masquage reposant sur le premier masque et disposé en regard de régions données de la couche superficielle, le deuxième masquage comportant une ouverture dévoilant le premier masquage, puis après amorphisation des deuxièmes zones, des étapes de :
   - retrait d'une portion du premier masquage à travers l'ouverture du deuxième masquage,
   - formation d'une grille de transistor dans l'ouverture du deuxième masquage,
   - retrait du deuxième masquage et de portions restantes du premier masquage, puis,
   - formation de blocs de source et de drain de part et d'autre de la grille.

Selon une autre possibilité de mise en oeuvre, préalablement à la formation du masquage, on réalise des étapes de :
- formation d'une grille sacrificielle sur la couche superficielle, puis,
- formation de blocs de source et de drain de part et d'autre de la grille sacrificielle,
- retrait de la grille sacrificielle de sorte à laisser place à une ouverture entre les blocs de source et de drain,

puis après formation du masquage dans l'ouverture et amorphisation des deuxièmes zones de la couche superficielle, on forme une grille dans l'ouverture prévue entre les blocs de source et de drain.

Selon une possibilité de mise en oeuvre le masquage utilisé lors de l'étape d'amorphisation peut avoir une contrainte intrinsèque.

Un autre mode de réalisation de la présente invention prévoit un transistor formé à partir d'un procédé tel que défini plus haut.

Un autre mode de réalisation de la présente invention prévoit un transistor sur un substrat de type semi-conducteur sur isolant comprenant une couche superficielle dans laquelle une structure de canal est formée, la couche superficielle comprenant une ou plusieurs première(s) zones semi-conductrices allongées à base de matériau semi-conducteur, le matériau semi-conducteur étant contraint dans une première direction donnée prise parallèlement à la longueur des première zones, le matériau semi-conducteur étant relaxé dans une deuxième direction prise parallèlement à la largueur des premières zones, la couche superficielle comprenant en outre des deuxièmes zones disposées de part et d'autre de la première zone et s'étendant parallèlement à la première direction, les deuxièmes zones étant à base d'un matériau semi-conducteur amorphe ou étant des zones isolantes à base de nitrure et/ou d'oxyde du matériau semi-conducteur.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
- les figures 1A-1G illustrent un exemple de procédé suivant un mode de réalisation de l'invention, dans lequel on relaxe une structure de canal contraint dans une direction orthogonale à celle dans laquelle le courant du canal est destiné à circuler;
- la figure 2 illustre une étape d'implantation pour la mise en oeuvre simultanée d'une transformation de zones semi-conductrices amorphes en zones isolantes et la relaxation d'une contrainte dans une zone semi-conductrice située entre ces zones isolantes dans une direction orthogonale à celle dans laquelle cette zone semi-conductrice s'étend ;

- la figure 3 illustre un exemple de réalisation dans lequel des zones semi-conductrices transformées en zones isolantes servent à définir un ou plusieurs contours isolants séparant et délimitant des zones actives de transistors ;
- la figure 4 illustre un exemple de substrat de départ possible pour un procédé suivant l'invention ;
- les figures 5A-5G illustrent un exemple de réalisation de type « gate first » dans lequel la relaxation de la structure de canal dans une direction orthogonale à celle dans laquelle le courant est destiné à circuler est réalisée dans une région localisée sur laquelle une grille de transistor est prévue ;
- les figures 6A-6D illustrent un exemple de réalisation de type « gate last » permettant de mettre en oeuvre la relaxation d'une zone semi-conductrice localisée entre des blocs de source et de drain ;
- la figure 7 illustre un exemple de procédé dans lequel on retire une épaisseur de zones de la couche superficielle d'un substrat transformées en zones isolantes ;
- la figure 8 illustre un exemple de procédé dans lequel on forme une grille sur des flancs latéraux d'une structure de canal ;
- les figures 9A et 9B donnent des exemples d'enchainements d'étapes de procédés de fabrications de dispositifs à transistors à canaux contraints selon une contrainte uni-axiale ;

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

En outre, dans la description ci-après, des termes qui dépendent de l'orientation, telle que « sous », « sur », « superficielle », « latérale », etc. d'une structure s'appliquent en considérant que la structure est orientée de la façon illustrée sur les figures.

### EXPOSÉ DÉTAILLÉ DE MODES DE RÉALISATION PARTICULIERS

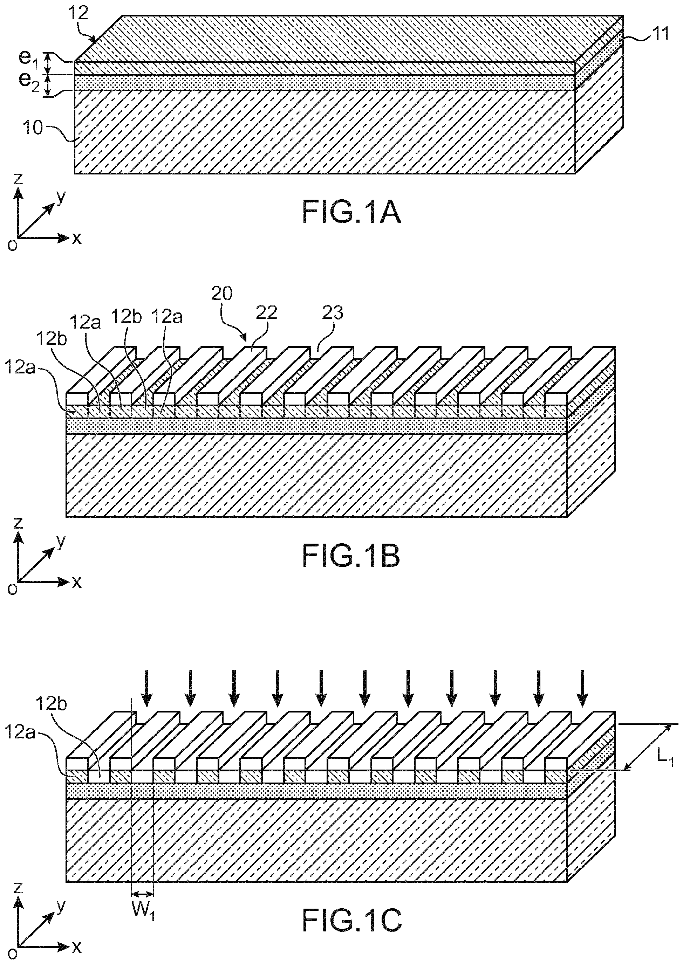

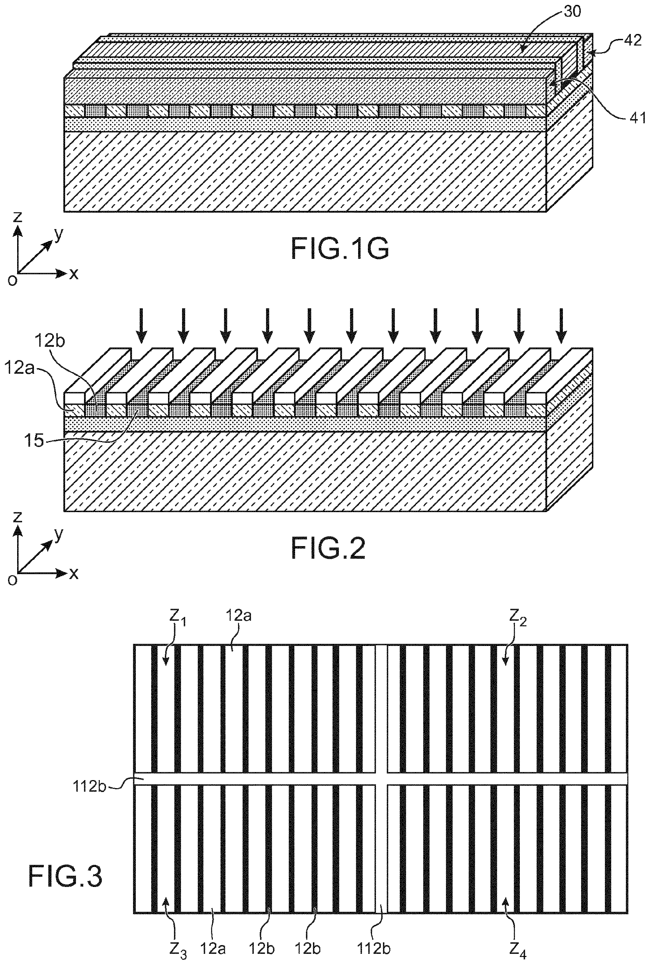

Un exemple de procédé de réalisation d'un transistor à structure de canal contraint va à présent être décrit en liaison avec les figures 1A-1G.

Le matériau de départ de ce procédé peut être un substrat de type semi-conducteur contraint sur isolant, et comprend ainsi une couche de support 10 semi-conductrice, une couche isolante 11 située sur et en contact avec la couche de support 10, ainsi qu'une couche semi conductrice 12 dite « superficielle » qui comporte une contrainte intrinsèque et qui est située sur et en contact avec la couche isolante 11.

Un exemple de substrat de type semi-conducteur contraint sur isolant est le substrat sSOI (SOI pour « strained silicon on insulator » ou « silicium contraint sur isolant ») dans lequel la couche semi conductrice 12 superficielle est à base de Si contraint en particulier selon une contrainte en tension et bi-axiale (figure 1A).

Le transistor réalisé peut être par exemple en technologie FDSOI, (pour « Fully Depleted Silicon On Insulator »). Dans ce cas, la couche superficielle semi conductrice 12 a une épaisseur e₁ qui peut être comprise par exemple entre 3 et 20 nm, tandis que la couche isolante 11 communément appelée de BOX (BOX pour « Buried Oxide ») et à base de SiO₂ peut avoir une épaisseur e₂ par exemple comprise entre 5 nm et 145 nm (les épaisseurs e₁ et e₂ étant des dimensions mesurées parallèlement à un axe z d'un repère orthogonal [O ;x ;y ;z] représenté sur la figure 1A).

On forme ensuite un masquage 20 sur la couche superficielle 12 contrainte. Le masquage 20 peut être un masque dur, par exemple à base de SiN ou de SiO₂.

Dans l'exemple de réalisation illustré sur la figure 1B, le masquage 20 est formé de plusieurs blocs 22 disposés respectivement sur des premières zones 12a de la couche superficielle 12. Les blocs 22 de masquage ont une forme oblongue ou allongée, avantageusement parallélépipédique. Par forme « allongée », on entend qu'ils ont une largeur (mesurée parallèlement à l'axe x du repère [O x ; y ; z]) inférieure et en particulier au moins 3 fois inférieure à leur longueur (mesurée quant à elle parallèlement à l'axe y du repère [O ; x ; y ; z]. Les blocs 22 de masquage peuvent être prévus avec une largeur comprise par exemple entre 5nm et 50nm et une longueur comprise par exemple entre 100nm et 10µm.

Le masquage comporte des ouvertures 23 dévoilant respectivement des deuxièmes zones 12b de la couche superficielle 12. Les ouvertures 23 ont également une forme oblongue ou allongée, par exemple rectangulaire, et s'étendent de part et d'autre des blocs 22 du masquage 20, le long de ces derniers.

Les premières zones 12a de la couche superficielle situées en regard respectivement des blocs 22 de masquage, ont ainsi une forme allongée. On effectue ensuite une amorphisation des deuxièmes zones 12b de la couche superficielle 12 dévoilées par les ouvertures 23 du masquage 20. Cette amorphisation est réalisée à l'aide d'une ou plusieurs implantation(s) ionique(s), les blocs 22 du masquage 20 protégeant les premières zones 12a de la couche superficielle sur lesquelles ils reposent. L'espèce implantée peut être par exemple du Si ou du Ge ou de l'As.

L'implantation amorphisante peut être réalisée par exemple à base d'atomes de Ge, ou de Si, ou d'As, ou de C, ou d'Ar, ou de P, ou de N, à une énergie choisie en fonction de la nature des espèces implantées, de la nature et épaisseur de la couche superficielle, de la densité de courant d'implantation et de la température du substrat lors de l'implantation. Pour rendre amorphe une couche de 10 nm à 30 nm de Si ou de SiGe, on peut réaliser une implantation de Si ou de Ge selon une énergie comprise entre 6 keV et 40 keV et selon une dose entre 5e14 et 1e15 atomes/cm².

Par exemple, pour amorphiser une épaisseur de 15 nm de Si, on peut implanter des ions Si à une énergie comprise entre 6 keV à 8 keV avec une dose de l'ordre de 1 x 10¹⁵ atomes/cm². Pour rendre amorphe une épaisseur de 30 nm de Si, on peut par exemple implanter des ions Si à une énergie comprise entre 14 keV et 25 keV à une dose de l'ordre de 5 x 10¹⁴atomes/cm².

On rend ainsi amorphe des deuxièmes zones 12b de la couche superficielle 12 qui s'étendent contre les première zones 12a de la couche superficielle non-implantées et dont la structure cristalline est conservée. L'amorphisation des deuxièmes zones 12b conduit à une relaxation de la contrainte dans les deuxième zones 12b dans une direction qui est orthogonale à celle dans laquelle les premières zones et les deuxième zones s'étendent, cette direction étant également parallèle au plan principal de la couche superficielle 12. Par « plan principal » de la couche superficielle 12, on entend ici un plan passant par la couche superficielle 12 et parallèle à un plan [O ; x ; y ] du repère orthogonal [O ; x ; y ; z].

Du fait de la forme des premières zones 12a et de leur agencement par rapport aux deuxièmes zones 12b qui leurs sont accolées, l'amorphisation induit également dans les premières zones 12a une relaxation de la contrainte dans la direction dans laquelle les premières zones 12a s'étendent.

Dans l'exemple de la figure 1C, la direction dans laquelle la relaxation se produit, est parallèle à la direction dans laquelle la largeur W₁ des première zones semi-conductrices 12a est mesurée. Autrement dit, une relaxation dans une direction parallèle à l'axe x du repère orthogonal [O ; x ; y ; z] est opérée.

Une contrainte est toutefois conservée dans les premières zones 12a dans une autre direction correspondant à la direction dans laquelle s'étendent les premières zones 12a, c'est à dire une direction prise parallèlement à la longueur L₁ des première zones semi-conductrices 12a. Autrement dit, une contrainte est conservée dans une direction prise parallèlement à l'axe y du repère orthogonal [O ; x ; y ; z].

La relaxation peut être ainsi réalisée sans gravure de la couche superficielle, autrement dit sans créer de relief, ce qui peut permettre de faciliter la réalisation ultérieure d'une grille de transistor. For une épaisseur e₁ donnée de la couche superficielle 10, on prévoit de préférence L₁ supérieur à 10 x e₁, et W₁ de préférence inférieur à 5 x e₁.

Ces premières zones 12a sont destinées à former une structure de canal de transistor. Un courant est destiné à circuler dans ce canal parallèlement à la première direction autrement dit parallèlement à l'axe y sur la figure 1C. En mettant en oeuvre une relaxation dans la deuxième direction, c'est-à-dire une direction orthogonale à celle dans laquelle un courant est destiné à circuler, on améliore les performances de la structure de canal en termes de mobilité des porteurs.

Pour permettre de relaxer davantage les premières zones 12a dans la deuxième direction, le masquage 20 peut lui-même être à base d'un matériau ayant une contrainte intrinsèque opposée à celle de la couche superficielle 12. Par exemple, pour permettre de relaxer des premières zones 12a à base de Si contraint en tension, un masquage compressif, par exemple à base de SiN compressif peut être utilisé. Dans un autre cas par exemple où les premières zones 12a sont à base de SiGe contraint en compression un masquage à base de SiN contraint en tension peut être mis en oeuvre.

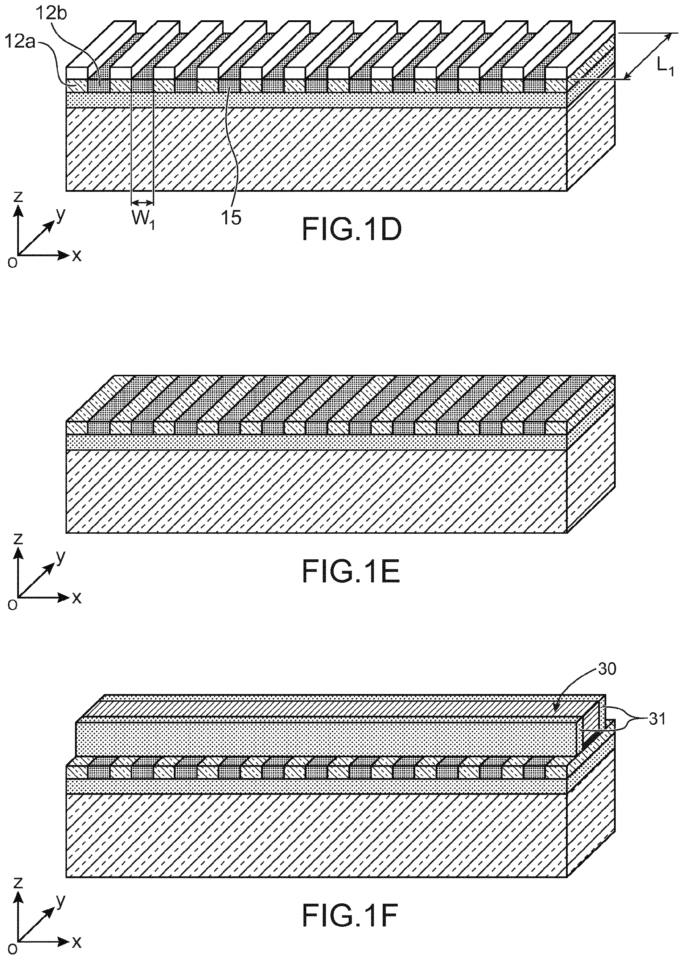

On peut ensuite transformer les deuxièmes zones 12b semi-conductrices en zones isolantes 15 (figure 1D). La transformation des deuxièmes zones semi-conductrices 12b, rendues amorphes, en zones isolantes de part et d'autre d'une première zone semi-conductrice 12a permet de mettre en oeuvre une isolation latérale de cette première zone semi-conductrice.

De préférence, cette transformation est réalisée en utilisant le masquage 20 qui sert de protection aux premières zones semi-conductrices 12a. On peut ainsi, avec un même masquage, créer une contrainte uni-axiale dans la couche superficielle 12 et former des zones isolantes 15 dans cette même couche superficielle 12.

La transformation des deuxièmes zones 12b en zones isolantes 15 peut être réalisée par exemple à l'aide d'une ou plusieurs implantations, en se servant à nouveau du masquage 20 comme d'un masque à implantation.

On peut par exemple implanter de l'oxygène afin de transformer les deuxièmes zones 12b semi-conductrices en zones d'oxyde semi-conducteur, en particulier d'oxyde de silicium.

On peut en variante implanter de l'azote afin de transformer les deuxièmes zones 12b semi-conductrices en zones de nitrure, en particulier de nitrure de silicium.

Une autre variante de réalisation prévoit une implantation d'oxygène et d'azote. Le procédé d'implantation utilisé peut être de type implantation par immersion plasma (PIII pour « Plasma Immersion Ion Implantation ») éventuellement suivi d'un recuit haute température et de courte durée. L'implantation peut être réalisée à une température comprise par exemple entre 200°C et 500°C. A la suite de l'implantation, un recuit thermique peut être effectué afin d'améliorer la qualité du matériau diélectrique obtenu.

Un tel recuit peut être effectué par exemple à une température haute comprise entre 300°C et 1100°C et selon une durée de préférence courte, par exemple comprise entre plusieurs minutes à faible température et plusieurs µs à haute température.

Un recuit thermique peut également être prévu afin de supprimer d'éventuels défauts créés lors de l'implantation dans la couche isolante 11 et/ou à une interface entre matériau diélectrique et matériau semi-conducteur.

Un autre procédé de transformation des deuxièmes zones 12b semi-conductrice en zones de matériau diélectrique 15 peut comprendre une oxydation des deuxièmes zones 12b, afin de créer un oxyde semi-conducteur dans les deuxièmes zones 12b. Dans ce cas, le masquage 20 est prévu de sorte à réaliser un masque à oxydation protégeant les premières zones semi-conductrices 12a. L'oxydation peut être réalisée par exemple à l'aide d'un plasma ou par oxydation thermique. Une nitruration, à l'aide d'un plasma peut être également effectuée.

On effectue ensuite un retrait du masquage 20 (figure 1E).

Dans le cas où le masquage 20 est à base de matériau diélectrique, ce matériau est de préférence différent de celui des zones isolantes 15, et prévu afin notamment de pouvoir retirer ce masquage 20 sélectivement sans altérer les zones isolantes 15. Dans un cas, par exemple, où les zones isolantes 15 de la couche superficielle sont à base d'oxyde de silicium, le masquage 20 peut avoir été prévu par exemple à base de nitrure de silicium. Dans un autre cas, par exemple, où les zones isolantes 15 sont à base de nitrure silicium, le masquage 20 peut avoir été prévu par exemple à base d'oxyde de silicium.

Après avoir retiré le masquage 20, une planarisation, par exemple par polissage CMP, peut être ensuite effectuée.

On forme ensuite une grille 30 pour le transistor. Pour cela, on dépose un empilement de grille comprenant un diélectrique et un matériau de grille, que l'on grave ensuite de manière à former un motif de grille. La grille 30 réalisée est disposée sur les premières zones 12a et s'étend orthogonalement aux première zones semi-conductrices 12a prises dans le sens de leur longueur L₁. Ainsi, dans l'exemple illustré sur la figure 1E, la grille 30 s'étend dans une direction parallèle à l'axe x du repère orthogonal [O ; x ; y ; z ].

On forme ensuite des espaceurs isolants 31 de part et d'autre de la grille (figure 1F).

Des blocs 41, 42 de source et de drain sont ensuite réalisés de part et d'autre de la grille, en effectuant une croissance par épitaxie sur des régions des premières zones semi-conductrices 12a.

Le matériau des blocs de source et de drain peut être prévu pour optimiser la contrainte uni-axiale conservée dans les premières zones semi-conductrices 12a. Dans le cas où le transistor réalisé est de type PMOS, les régions 41, 42 de source et de drain peuvent être par exemple à base de SiGe. Dans un autre cas par exemple où le transistor réalisé est de type NMOS, les blocs 41, 42 de source et de drain peuvent être par exemple à base de Si dopé au carbone (Si:C).

Une variante de l'exemple de procédé précédemment décrit est illustrée sur la figure 2 et prévoit, avantageusement, de réaliser concomitamment l'amorphisation des deuxièmes zones 12b conduisant à la relaxation des premières zones 12a, et la transformation des deuxièmes zones en zones diélectriques, à l'aide d'au moins une étape commune d'implantation. Cette implantation des deuxièmes zones 12b peut être réalisée à l'aide par exemple de N ou de O. L'énergie et la dose sont adaptées en fonction des matériaux et épaisseur de la cible. On peut en particulier réaliser une implantation par immersion plasma PIII, technique qui permet d'implanter à forte dose selon un temps raisonnable. Par exemple une implantation PIII d'oxygène selon une énergie de l'ordre de 1 keV, une dose de l'ordre de 1^{e}17 atomes/cm² permet de transformer une couche de Si d'épaisseur e₁ inférieure à 8 nm en oxyde.

Selon un autre exemple, une implantation PIII d'oxygène selon une dose de l'ordre de 1^{e}17 atomes/cm² à une énergie de 2.44 keV permet de transformer une couche de Si d'épaisseur e1< 15 nm en oxyde.

Selon un autre exemple, pour effectuer une nitruration d'une couche de Si inférieure à 10 nm, une implantation d'azote à une dose entre 6.10¹⁶ et 1*10¹⁷ cm⁻², une tension de 2400 V permet de former une couche de nitrure.

Ces implantations sont de préférence suivies d'un recuit à haute température, par exemple un recuit de type communément appelé « spike » de très courte durée à 950°C.

Selon une possibilité de mise en oeuvre de l'un ou l'autre des exemples de procédé précédemment décrits, lors des étapes décrites en liaison avec les figures 1C-1D ou la figure 2, certaines zones 112b de la couche superficielle 12 rendues amorphes puis transformées en zones isolantes peuvent être destinées à former un contour isolant de séparation entre des zones Z1, Z2, Z3, Z4 actives ou des zones de transistors de la couche superficielle 12 (figure 3). Ainsi, tout en relaxant les premières zones 12a de la couche superficielle on réalise des tranchées d'isolation STI (pour « Shallow trench isolation »).

Une autre variante de l'un ou l'autre des exemples de procédé précédemment décrit prévoit de partir d'un substrat semi-conducteur contraint sur isolant cette fois de type sSiGeOI (pour « strained silicon germanium on insulator »). Un tel substrat est ainsi doté d'une couche semi conductrice 212 superficielle est à base de SiGe contraint en compression bi-axiale (figure 3).

Dans ce cas, l'amorphisation des deuxièmes zones semi-conductrices 12b de la couche superficielle 212 permet de relaxer la contrainte compressive dans une direction orthogonale à la direction d'allongement des premières zones semi-conductrices dont la structure cristalline a été préservée, tout en conservant une contrainte compressive dans la direction d'allongement des premières zones semi-conductrices 12a.

Un exemple de méthode pour former une couche de SiGe contraint sur isolant peut comprendre le dépôt d'une couche de SiGe ou d'un empilement d'une fine couche de Si et d'une couche de SiGe sur la couche superficielle de Si contraint d'un substrat sSOI, puis de réaliser une oxydation de sorte à enrichir contraint en Germanium la couche superficielle de Si. On retire ensuite l'oxyde.

On peut également mettre en oeuvre un procédé de relaxation de contrainte bi-axiale par amorphisation tel que décrit précédemment sur un substrat comprenant une région adaptée pour la mise en oeuvre de transistors de type N et comprenant une contrainte bi-axiale en tension et une autre région adaptée pour la mise en oeuvre de transistors de type P et comprenant une contrainte bi-axiale en compression.

Un tel substrat peut être par exemple un substrat sSOI ayant une couche superficielle à base de Si contraint en tension dont on transforme une région en cSiGe, par un procédé d'enrichissement en Germanium tel qu'évoqué précédemment.

On peut par exemple effectuer le procédé de relaxation par amorphisation décrit précédemment en liaison avec la figure 1C dans une région de la couche superficielle 12 dédiée aux transistors de type N tout en masquant totalement une autre région de la couche superficielle 12 dédiée aux transistors de type P.

Puis, après avoir retiré le masquage on transforme cette autre région de en région cSiGe par enrichissement Germanium.

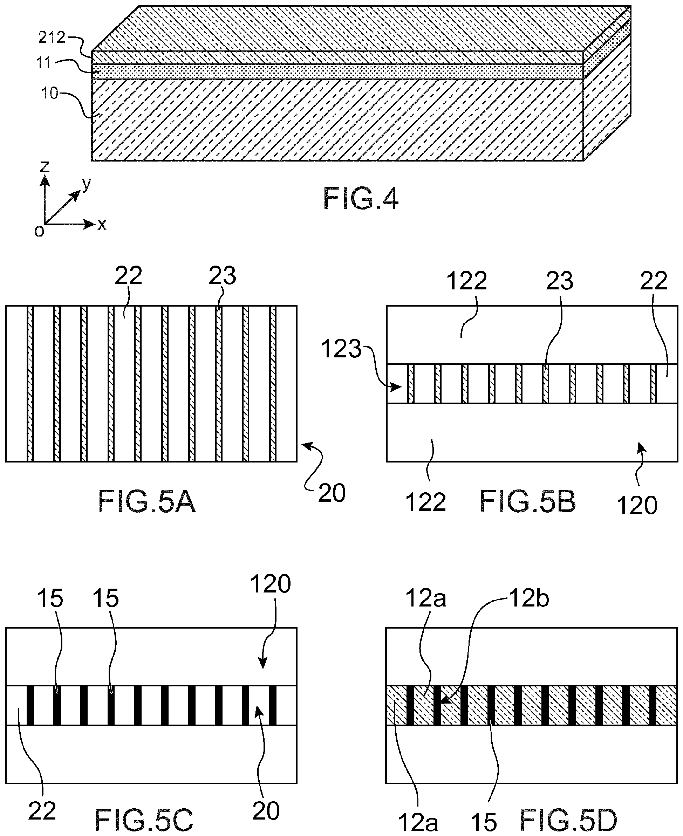

Selon une autre variante, un procédé tel que décrit précédemment en liaison avec la figure 1C dans lequel on rend amorphe des zones d'une couche superficielle contrainte d'un substrat semi-conducteur sur isolant, peut être également effectué uniquement dans une région localisée de la couche superficielle 12 sur laquelle la grille est destinée à être réalisée. Cela permet de ne pas modifier les régions de la couche superficielle dans lesquelles et/ou sur lesquelles les blocs de source et de drain sont destinées à être formés. Une telle variante est illustrée sur les figures 5A-5G.

Après avoir formé un premier masquage 20 (dont la réalisation a été décrite précédemment en liaison avec la figure 1B et qui est représenté sur la figure 5A selon une vue de dessus), on réalise un deuxième masquage 120. Le deuxième masquage 120 peut être à base du même matériau que celui du premier masquage 20, par exemple du SiN ou du SiO₂.

Ce deuxième masquage 120 comporte des blocs 122 disposés en regard des emplacements respectifs d'une région de source et d'une région de drain du transistor destinées à être réalisées. Une ouverture 123 disposée entre les blocs 122 du deuxième masquage, définit un emplacement pour la grille du transistor destinée à être formée ultérieurement. Cette ouverture 123 dévoile ainsi les blocs 22 du premier masquage 20 et les ouvertures 23 prévues de part et d'autre des blocs 22 du premier masquage 23 (figure 5B).

On réalise ensuite au moins une implantation ionique de sorte à rendre amorphes les deuxièmes zones 12b de la couche superficielle 12 qui sont dévoilées par les ouvertures 23 du premier masquage 20 elles-mêmes dévoilées par l'ouverture 123 du deuxième masquage 120.

Après avoir ainsi relaxé la contrainte dans les premières zones 12a dans une direction orthogonale à celle dans laquelle elles s'étendent, on peut transformer les deuxièmes zones 12b rendues amorphes en zones isolantes. Pour cela, on réalise par exemple une implantation à travers les ouvertures 23 et 123 du premier masquage 20 et du deuxième masquage 120 (figure 5C).

On retire ensuite une portion du premier masquage 20 située au fond de l'ouverture 123. On dévoile ainsi les premières zones 12a de la couche superficielle 12 en contrainte uni-axiale et les deuxièmes zones 12b de la couche superficielle 12 transformées en zones isolantes (figure 5D).

Dans le cas où les masquages 20 et 120 sont à base du même matériau, pour permettre le retrait d'une portion du premier masquage 20 tout en conservant suffisamment du deuxième masquage 120, on peut prévoit ce dernier avec une épaisseur supérieure à celle des blocs du premier masquage 20.

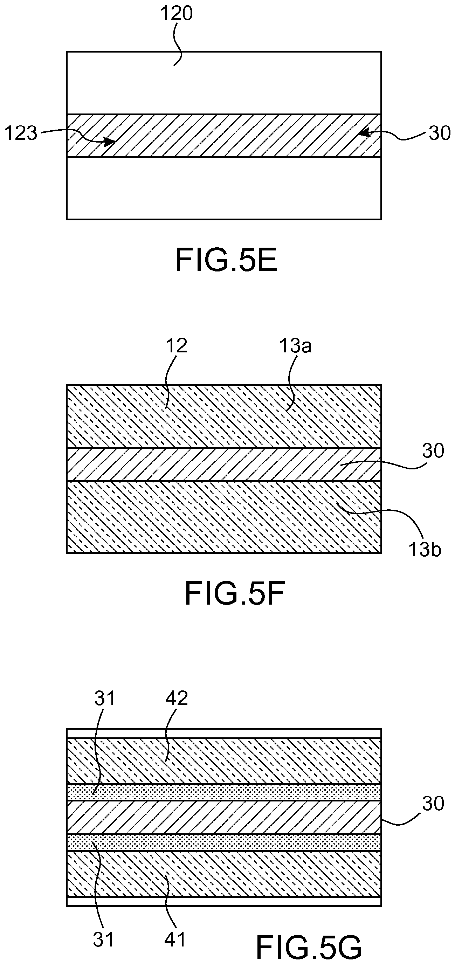

Puis, on forme une grille 30 dans l'ouverture 123 du deuxième masquage 120 (figure 5E).

On retire ensuite le deuxième masquage 120 de sorte à dévoiler des régions 13a, 13b de la couche superficielle 12 dans lesquelles et/ou sur lesquelles les blocs de source et de drain sont destinées à être formés (figure 5F).

Puis, on forme des espaceurs isolants 31 contre les flancs latéraux de la grille 30. On forme ensuite par épitaxie les blocs de source et de drain (figure 5G).

Avec l'exemple de réalisation qui vient d'être donné, la réalisation des blocs de source et de drain est plus aisée que dans celui décrit des figures 1A-1G. En effet, elle se fait sur uniquement sur des régions 13a, 13b de matériau semi-conducteur.

Dans les exemples de procédés qui viennent d'être décrits, on réalise la grille avant de former des blocs de source et de drain. En variante de ces procédés de type que l'on peut qualifier de « grille en premier » (« gate first » selon la terminologie anglo-saxonne), on peut mettre en oeuvre des blocs de source et de drain en s'appuyant sur une grille sacrificielle puis remplacer cette grille sacrificielle en ayant au préalable réalisé la transformation de la contrainte bi-axiale en contrainte uni-axiale dans les premières zones 12a de la couche superficielle 12.

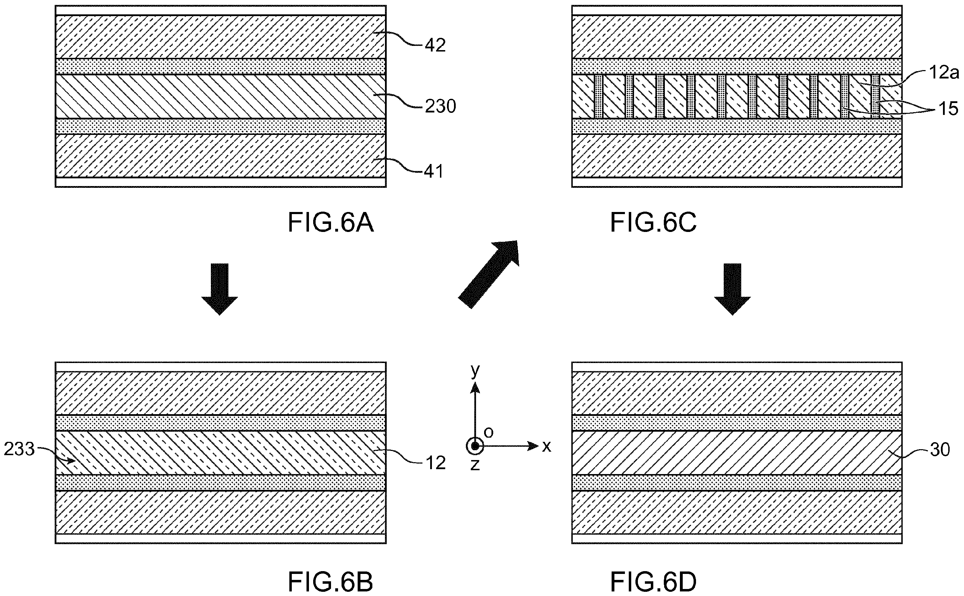

Une telle variante de procédé, de type que l'on peut qualifier de « grille en dernier » (« gate last » selon la terminologie anglo-saxonne), est illustrée sur les figures 6A-6D.

Dans cet exemple, on forme une grille sacrificielle 230 sur la couche superficielle 12 en contrainte bi-axiale et des espaceurs isolants 31 contre des flancs de la grille sacrificielle 230. La grille sacrificielle peut être par exemple à base de polysilicium.

Puis, des blocs 41, 42 de source et de drain sont réalisés de part et d'autre de la grille sacrificielle 230 (figure 6A).

On retire ensuite la grille sacrificielle 230. L'emplacement de la grille sacrificielle laissé vacant forme une ouverture 233 dévoilant la couche superficielle 12 du substrat (figure 6B).

Dans cette ouverture 233, on forme alors le masquage 20 tel que décrit précédemment en liaison avec la figure 1B, et comportant des blocs 22 parallèles disposés respectivement sur des premières zones 12a de la couche superficielle 12 avec des ouvertures 23 parallèles prévues entre les blocs 22 du masquage 20 et dévoilant des deuxièmes zones 12b de la couche superficielle 12.

A travers l'ouverture 233 entre les blocs de source et de drain et les ouvertures 23 du masquage 20, on effectue ensuite l'amorphisation des deuxièmes zones 12b de sorte à transformer la contrainte bi-axiale en contrainte uni-axiale dans les premières zones 12a. On transforme également les deuxièmes zones 12b semi-conductrices en zones isolantes 15 (figure 6C).

On forme ensuite une grille 30 de remplacement dans l'ouverture 233 (figure 6D).

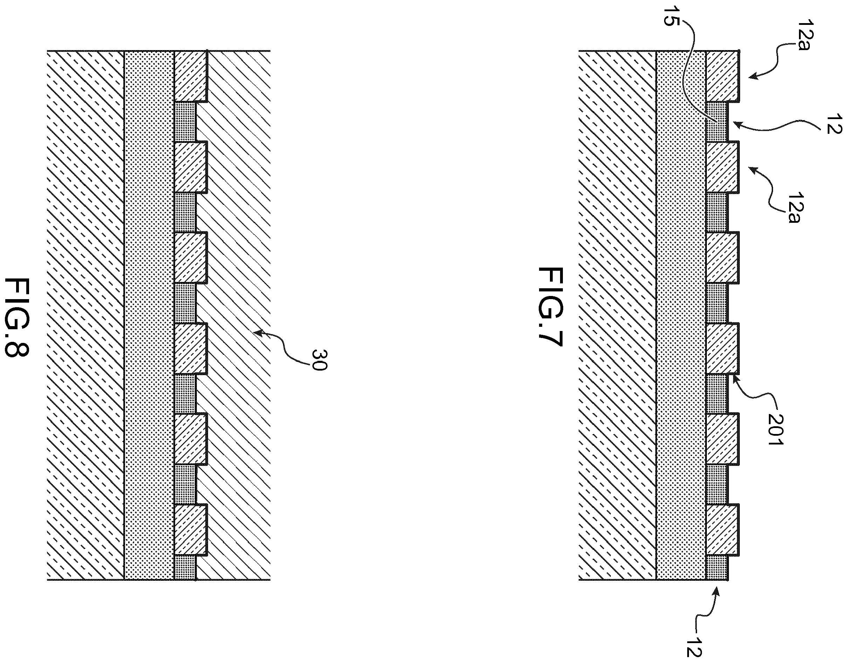

Une méthode pour permettre d'augmenter la contrainte dans les premières zones semi-conductrices 12a et plus particulièrement dans une direction parallèle à leur longueur L₁, est illustrée sur la figure 7. Pour cela, on procède au retrait d'une épaisseur donnée des deuxièmes zones 12b de la couche superficielle 12 après que ces zones 12b aient été transformées en zones 12b de matériau diélectrique 15. On dévoile ainsi une portion de flancs latéraux 201 des premières zones semi-conductrices 12a.

L'épaisseur retirée peut être par exemple comprise entre 2nm et 15nm.

On peut alors ensuite former une grille 30 qui épouse la forme des premières zones semi-conductrice 12a. Cette grille est ainsi agencée contre une portion des flanc latéraux 201 des premières zones semi-conductrices 12a. Un tel agencement de grille illustré sur la figure 8 permet un contrôle amélioré du canal. La grille 30 peut être réalisée comme dans l'exemple de procédé décrit précédemment en liaison avec les figures 6A-6D. Ainsi, la grille 30 peut être formée en remplacement d'une grille sacrificielle et mise en oeuvre par un procédé de type damascène dans laquelle on remplit une ouverture d'un masque.

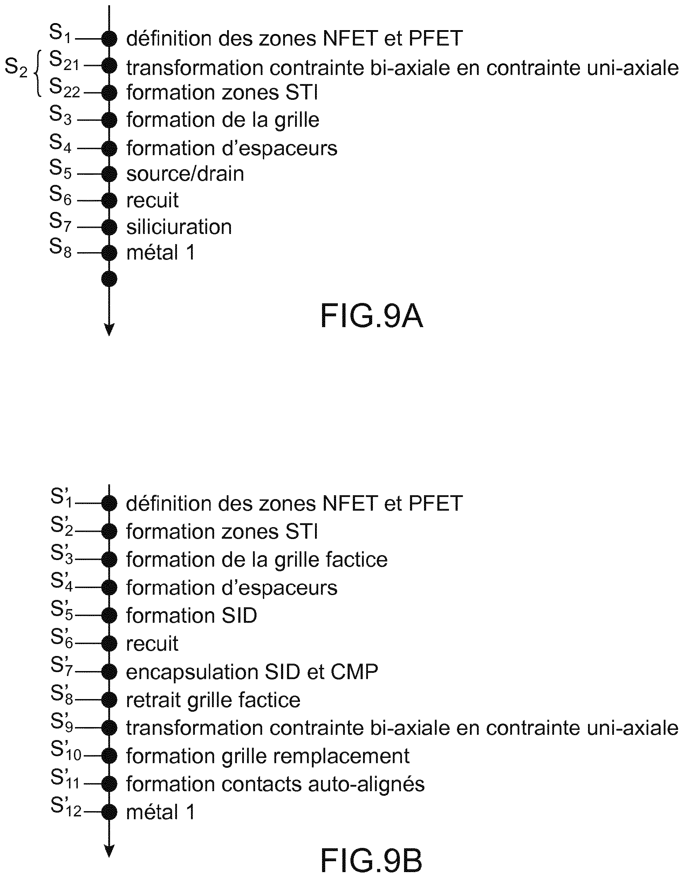

Un exemple particulier d'enchainement d'étapes de fabrication d'un dispositif microélectronique à transistors intégrant une étape d'amorphisation pour transformer une contrainte bi-axiale en contrainte uni-axiale, est donné sur la figure 9A.

Le procédé est dans cet exemple de type « grille en premier » (« gate first » selon la terminologie anglo-saxonne).

On définit tout d'abord (étape S1) des zones dédiées aux transistors NFET et PFET dans la couche superficielle du substrat en contrainte bi-axiale.

Puis (étape S21), on effectue la transformation de la contrainte bi-axiale en contrainte uni-axiale telle que décrite précédemment par amorphisation de zones de la couche superficielle.

On transforme les zones amorphes en zones diélectriques, ce qui peut permettre de former des zones d'isolation STI (étape S22, cette étape S22 et l'étape S21 pouvant être mutualisées et réalisées en une seule étape S2).

On forme ensuite une grille (étape S3), puis des espaceurs (étape S4). On réalise ensuite les régions de source et de drain (étape S5), de recuit de (étape S6).

Puis, on effectue une étape de silicuration et de réalisation de contacts (étape S7). Ensuite, on peut former un premier niveau métallique d'interconnexion (étape S8).

Un autre exemple particulier d'enchainement d'étapes de fabrication d'un dispositif microélectronique à transistors intégrant une étape d'amorphisation pour transformer une contrainte bi-axiale en contrainte uni-axiale est donné sur la figure 9B.

Le procédé est dans cet autre exemple de type « grille en dernier » (« gate last » selon la terminologie anglo-saxonne). On définit tout d'abord (étape S'1) des zones dédiées aux transistors NFET et PFET dans la couche superficielle du substrat en contrainte bi-axiale. Puis (étape S'21) forme des zones d'isolation STI . On réalise ensuite une grille factice (étape S'3), puis des espaceurs (étape S'4). On réalise ensuite les régions de source et de drain (étape S'5), de recuit de (étape S'6).

Puis, on effectue une étape d'encapsulation des régions de source et de drain et de polissage CMP (étape S'7).

On retire alors la grille factice (étape S'8). Puis, on effectue la transformation de la contrainte bi-axiale en contrainte uni-axiale par amorphisation de zones de la couche superficielle (étape S'9).

Ensuite, on forme la grille de remplacement (étape S'10), puis des contacts auto-alignés (étape S'11). Puis on réalise un premier niveau métallique d'interconnexion (étape S'12).

Un procédé selon l'un ou l'autre des exemples de procédés décrits précédemment peut être adapté à la réalisation de transistors de structure de canal non nécessairement planaire. Par exemple des transistors en technologie de type finFET à canal en contrainte uni-axiale peuvent être réalisés.

## Revendications

1. Procédé de réalisation de transistor(s) à structure de canal contraint comprenant des étapes consistant à :
- former un masquage (20) sur une couche superficielle (12) d'un substrat de type semi-conducteur sur isolant comprenant une couche de support (10), une couche isolante (11) séparant la couche de support de la couche superficielle, la couche superficielle (12) étant à base d'un matériau semi-conducteur (13,14) contraint selon une contrainte bi-axiale, le masquage (20) étant formé d'au moins un bloc (22) de forme allongée disposé sur une première zone (12a) de la couche superficielle, la première zone (12a) ayant une longueur (L₁) mesurée parallèlement à une première direction et une largeur mesurée parallèlement à une deuxième direction, la première zone (12a) étant apte à former une structure de canal du transistor dans laquelle un courant est destiné à circuler dans la première direction, le masquage (20) étant configuré de sorte qu'une ou plusieurs ouvertures (23) de forme allongée et s'étendant parallèlement à la première direction sont disposées de part et d'autre du bloc (22) de masquage et dévoilent respectivement des deuxièmes zones (12b) de la couche superficielle disposées de part et d'autre de la première zone (12a),
- réaliser au moins une implantation ionique de la couche superficielle à travers les ouvertures (23) du masquage (20), de sorte à rendre amorphe les deuxièmes zones (12b) et à induire une relaxation de la première zone (12a) dans la deuxième direction,
le procédé comprenant en outre une étape consistant à transformer les deuxièmes zones (12b) de la couche superficielle (12) dévoilées par les ouvertures (23) du masquage (20) en zones isolantes (15).

2. Procédé selon la revendication 1, dans lequel la transformation des deuxièmes zones (12b) en zones isolantes (15) est réalisée à l'aide d'au moins une étape d'implantation.

3. Procédé selon la revendication 2, dans lequel l'amorphisation des deuxièmes zones (12b) et la transformation des deuxièmes zones (12b) en zones isolantes (15) sont réalisées concomitamment par implantation.

4. Procédé selon la revendication 3, dans lequel la transformation des deuxièmes zones (12b) en zones isolantes (15) comprend au moins une étape d'oxydation thermique.

5. Procédé selon l'une des revendications 1 à 4, dans lequel au moins une zone isolante (15) formée par transformation des deuxièmes zones (12b), forme une séparation avec un autre transistor.

6. Procédé selon l'une des revendications 1 à 5, dans lequel, après transformation des deuxièmes zones (12b) rendues amorphes en zones isolantes (15), on retire une épaisseur de ces zones isolantes (15).

7. Procédé selon l'une des revendications 1 à 6, comprenant en outre, après amorphisation des deuxièmes zones (12b) de la couche superficielle (12), des étapes consistant à :
- retirer le masquage (20), puis
- former au moins une grille (30) de transistor sur la première zone semi-conductrice (12a), la grille (30) s'étendant parallèlement à la deuxième direction, puis
- croissance sur le matériau semi-conducteur de la couche superficielle (12) de blocs (41, 42) de source et de drain de part et d'autre de la grille (30).

8. Procédé selon l'une des revendications 1 à 6, dans lequel le masquage (20) est un premier masquage, le procédé comprenant en outre après formation du premier masquage (20) et préalablement à l'amorphisation des deuxièmes zones (12b), la formation d'un deuxième masquage (120) reposant sur le premier masque (20) et disposé en regard de régions données de la couche superficielle, le deuxième masquage (120) comportant une ouverture (123) dévoilant le premier masquage (20), puis après amorphisation des deuxièmes zones (12b), des étapes de
- retrait d'une portion du premier masquage (20) à travers l'ouverture (123) du deuxième masquage (120),
- formation d'une grille (30) dans l'ouverture (123) du deuxième masquage (120),
- retrait du deuxième masquage (120) et de portions restantes du premier masquage (20), puis,
- formation des blocs (41, 42) de source et de drain de part et d'autre de la grille (30).

9. Procédé selon l'une des revendications 1 à 6, dans lequel préalablement à la formation du masquage (20), on réalise des étapes de :
- formation d'une grille sacrificielle (230) sur la couche superficielle (12), puis,
- formation de blocs (41, 42) de source et de drain de part et d'autre de la grille sacrificielle (230),
- retrait de la grille sacrificielle de sorte à laisser place à une ouverture (233) entre les blocs (41, 42) de source et de drain,
puis après formation du masquage (20) dans l'ouverture (230) et amorphisation des deuxièmes zones (12b) de la couche superficielle (12), on forme une grille (30) dans l'ouverture (233) entre les blocs (41, 42) de source et de drain.

10. Procédé selon l'une des revendications 1 à 9, dans lequel le masquage (20) a une contrainte intrinsèque.

## Patentansprüche

1. Verfahren zur Herstellung von (einem) Transistor(en) mit unter Spannung stehender Kanalstruktur, umfassend die folgenden Schritte:
- Bilden einer Maskierung (20) auf einer Oberflächenschicht (12) eines Substrats vom Typ Halbleiter auf Isolator, umfassend eine Trägerschicht (10), wobei eine isolierende Schicht (11) die Trägerschicht von der Oberflächenschicht separiert, wobei die Oberflächenschicht (12) auf Basis eines Halbleitermaterials (13, 14) ist, das gemäß einer biaxialen Spannung unter Spannung steht, wobei die Maskierung (20) mit wenigstens einem Block (22) mit länglicher Form gebildet ist, der auf einer ersten Zone (12a) der Oberflächenschicht angeordnet ist, wobei die erste Zone (12a) eine parallel zu einer ersten Richtung gemessene Länge (L₁) und eine parallel zu einer zweiten Richtung gemessene Breite hat, wobei die erste Zone (12a) dazu ausgelegt ist, eine Transistorkanalstruktur zu bilden, bei der ein Strom in der ersten Richtung zirkulieren soll, wobei die Maskierung (20) derart konfiguriert ist, dass eine oder mehr Öffnungen (23) mit länglicher Form, die sich parallel zur ersten Richtung erstrecken, auf beiden Seiten des Maskierungsblocks (22) angeordnet sind und jeweils zweite Zonen (12b) der Oberflächenschicht enthüllen, die auf beiden Seiten der ersten Zone (12a) angeordnet sind,
- Realisieren wenigstens einer Ionenimplantation der Oberflächenschicht durch die Öffnungen (23) der Maskierung (20) hindurch derart, dass die zweiten Zonen (12b) amorph gemacht werden und eine Relaxation der ersten Zone (12a) in der zweiten Richtung induziert wird,
wobei das Verfahren ferner einen Schritt umfasst, der darin besteht, die zweiten Zonen (12b) der Oberflächenschicht (12), die durch die Öffnungen (23) der Maskierung (20) enthüllt werden, in isolierende Zonen (15) zu transformieren.

2. Verfahren nach Anspruch 1, bei dem die Transformation der zweiten Zonen (12b) in isolierende Zonen (15) mit Hilfe wenigstens eines Implantationsschritts realisiert wird.

3. Verfahren nach Anspruch 2, bei dem die Amorphisierung der zweiten Zonen (12b) und die Transformation der zweiten Zonen (12b) in isolierende Zonen (15) gleichzeitig durch Implantation realisiert werden.

4. Verfahren nach Anspruch 3, bei dem die Transformation der zweiten Zonen (12b) in isolierende Zonen (15) wenigstens einen Schritt der thermischen Oxidation umfasst.

5. Verfahren nach einem der Ansprüche 1 bis 4, bei dem wenigstens eine durch Transformation der zweiten Zonen (12b) gebildete isolierende Zone (15) eine Separation mit einem anderen Transistor bildet.

6. Verfahren nach einem der Ansprüche 1 bis 5, bei dem man nach der Transformation der amorph gemachten zweiten Zonen (12b) in isolierende Zonen (15) eine Dicke dieser isolierenden Zonen (15) entfernt.

7. Verfahren nach einem der Ansprüche 1 bis 6, ferner umfassend, nach der Amorphisierung der zweiten Zonen (12b) der Oberflächenschicht (12), die folgenden Schritte:
- Entfernen der Maskierung (20), dann
- Bilden wenigstens eines Transistorgates (30) auf der ersten Halbleiterzone (12a), wobei sich das Gate (30) parallel zur zweiten Richtung erstreckt, dann
- Aufwachsen, auf dem Halbleitermaterial der Oberflächenschicht (12), von Source- und von Drain-Blöcken (41, 42) auf beiden Seiten des Gates (30).

8. Verfahren nach einem der Ansprüche 1 bis 6, bei dem die Maskierung (20) eine erste Maskierung ist, wobei das Verfahren ferner nach der Bildung der ersten Maskierung (20) und vor der Amorphisierung der zweiten Zonen (12b) die Bildung einer zweiten Maskierung (120) umfasst, die auf der ersten Maskierung (20) ruht und gegenüber gegebenen Regionen der Oberflächenschicht angeordnet ist, wobei die zweite Maskierung (120) eine Öffnung (123) umfasst, die die erste Maskierung (20) enthüllt, und dann nach der Amorphisierung der zweiten Zone (12b), die folgenden Schritte:
- Entfernen einen Bereichs der ersten Maskierung (20) durch die Öffnung (123) der zweiten Maskierung (120) hindurch,
- Bilden eines Gates (30) in der Öffnung (123) der zweiten Maskierung (120),
- Entfernen der zweiten Maskierung (120) und von verbleibenden Bereichen der ersten Maskierung (20), und dann
- Bilden der Source- und der Drain-Blöcke (41, 42) auf beiden Seiten des Gates (30).

9. Verfahren nach einem der Ansprüche 1 bis 6, bei dem man vor der Bildung der Maskierung (20) die folgenden Schritte realisiert:
- Bilden eines Opfergates (230) auf der Oberflächenschicht (12), dann
- Bilden von Source- und von Drain-Blöcken (41, 42) auf beiden Seiten des Opfergates (230),
- Entfernen des Opfergates derart, dass Platz für eine Öffnung (233) zwischen den Source- und den Drain-Blöcken (41, 42) gelassen wird,
und man dann nach der Bildung der Maskierung (20) in der Öffnung (230) und der Amorphisierung der zweiten Zonen (12b) der Oberflächenschicht (12) ein Gate (30) in der Öffnung (233) zwischen den Source- und den Drain-Blöcken (41, 42) bildet.

10. Verfahren nach einem der Ansprüche 1 bis 9, bei dem die Maskierung (20) eine intrinsische Spannung aufweist.

## Claims

1. Method for creating stressed channel structure transistors comprising steps consisting of:
- forming a mask (20) on a surface layer (12) of a semiconductor-on-insulator type substrate comprising a support layer (10), an insulating layer (11) separating the support layer from a surface layer, the surface layer (12) being based on a semiconductor material (13, 14) stressed with a biaxial stress, the mask (20) being formed from at least one block (22) of elongated form arranged on a first zone (12a) of the surface layer, the first zone (12a) having a length (L₁) measured parallel to a first direction and a width measured parallel to a second direction, the first zone (12a) being capable of forming a transistor channel structure wherein a current is meant to pass in the first direction, the mask (20) being configured such that one or several openings (23) of elongated form and which extend parallel to the first direction are arranged on either side of the masking block (22) and respectively reveal the second zones (12b) of the surface layer arranged on either side of the first zone (12a),
- execution of at least one ion implantation of the surface layer through the openings (23) in the mask (20), so as to render the second zones (12b) amorphous and to induce relaxation of the first zone (12a) in the second direction,
the method furthermore comprising a step consisting of transforming the second zones (12b) of the surface layer (12) revealed by the openings (23) of the mask (20) into insulating zones (15).

2. Method according to claim 1 wherein the transformation of the second zones (12b) into insulating zones(15) is achieved using at least one implantation step.

3. Method according to claim 2, wherein the amorphisation of the second zones (12b) and the transformation of the second zones (12b) into insulating zones (15) are carried out concomitantly by implantation.

4. Method according to claim 2 wherein the transformation of the second zones (12b) into insulating zones (15) comprises at least one thermal oxidation step.

5. Method according to any of the claims 1 to 4, wherein at least one insulating zone (15) formed by transformation of the second zones (12b), forms a separation with another transistor.

6. Method according to any of the claims 1 to 5, wherein, after transformation of the second zones (12b) that have been rendered amorphous into insulating zones (15), a thickness of these insulating zones (15) is removed.

7. Method according to any of the claims 1 to 6, furthermore comprising, after amorphisation of the second zones (12b) of the surface layer (12), steps consisting of:
- removing the mask (20), then
- forming at least one transistor gate (30) on the first semiconductor zone (12a), the gate (30) extending parallel to the second direction, then
- growth, on the semiconductor material of the surface layer (12), of source and drain blocks (41, 42) on either side of the gate (30).

8. Method according to any of the claims 1 to 6, wherein the mask (20) is a first mask, the method furthermore comprising, after formation of the first mask (20) and prior to the amorphisation of the second zones (12b), the formation of a second mask (120) resting on the first mask (20) and arranged opposite given regions of the surface layer, the second mask comprising an opening revealing the first mask, then after amorphisation of the second zones, steps for
- removal of a portion of the first mask (20) through the opening (123) of the second mask (120),
- formation of a gate (30) in the opening (123) of the second mask (120),
- removal of the second mask (120) and of remaining portions of the first mask (20), then,
- formation of source and drain blocks (41,42) on either side of the gate (30).

9. Method according to any of the claims 1 to 6, wherein, prior to the formation of the mask (20), the following steps are carried out:
- formation of a sacrificial gate (230) on the surface layer (12), then,
- formation of source and drain blocks (41, 42) on either side of the sacrificial gate (230),
- removal of the sacrificial gate so as to leave room for an opening (233) between the source and drain blocks (41, 42),
then, after formation of the mask (20) in the opening (230) and amorphisation of the second zones (12b) of the surface layer (12), a gate (30) is formed in the opening (233) between the source and drain blocks (41, 42).

10. Method according to any of the claims 1 to 9, wherein the mask (20) has an intrinsic stress.
